(19) Europäisches Patentamt / European Patent Office / Office européen des brevets

(11) **EP 4 113 210 A1**

(12) **EUROPEAN PATENT APPLICATION**

(43) Date of publication:
**04.01.2023 Bulletin 2023/01**

(21) Application number: **21183254.8**

(22) Date of filing: **01.07.2021**

(51) International Patent Classification (IPC):
**G03F 7/20** (2006.01)

(52) Cooperative Patent Classification (CPC):
**G03F 7/705; G03F 7/70616; G03F 7/70633**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
• **BOTTEGAL, Giulio
5500 AH Veldhoven (NL)**
• **JONGEN, Martijn
5500 AH Veldhoven (NL)**

(74) Representative: **ASML Netherlands B.V.
Corporate Intellectual Property
P.O. Box 324
5500 AH Veldhoven (NL)**

(54) **A METHOD OF MONITORING A MEASUREMENT RECIPE AND ASSOCIATED METROLOGY METHODS AND APPARATUSES**

(57) Disclosed is a method of determining a reliability metric describing a reliability of metrology signal and/or a parameter of interest value derived therefrom and associated apparatuses. The method comprises obtaining a trained inference model for inferring a value for a parameter of interest from a measurement signal and one or more measurement signals and/or respective one or more values of a parameter of interest derived therefrom using said trained inference model. At least one reliability metric value is determined for the one or more measurement signals and/or respective one or more values of a parameter of interest, the reliability metric describing a reliability of one or more measurement signals and/or respective one or more values of a parameter of interest with respect to an accurate prediction space associated with the trained inference model.

Fig. 6

**Description**

<u>BACKGROUND</u>

Field of the Invention

0001 The present invention relates to a metrology apparatus and methods usable, for example, to perform metrology in the manufacture of devices by lithographic techniques. The invention further relates to such methods for monitoring a parameter of interest such as overlay in a lithographic process.

Background Art

0002 A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

0003 In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

0004 Examples of known scatterometers include angle-resolved scatterometers of the type described in US2006033921A1 and US2010201963A1. The targets used by such scatterometers are relatively large, e.g., 40$\mu$m by 40$\mu$m, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

0005 A metrology method is known where a weighting is applied to a metrology signal to translate this signal to a parameter of interest value such as overlay. This weighting may be determined using a trained model. It would be desirable to improve monitoring of the weighting and/or model to assess whether it is still providing reliable inference of the parameter of interest value.

<u>SUMMARY OF THE INVENTION</u>

0006 The invention in a first aspect provides a method of determining a reliability metric describing a reliability of metrology signal and/or a parameter of interest value derived therefrom, the method comprising; obtaining a trained inference model for inferring a value for a parameter of interest from a measurement signal; obtaining one or more measurement signals and/or respective one or more values of a parameter of interest derived therefrom using said trained inference model; and determining at least one reliability metric value for the one or more measurement signals and/or respective one or more values of a parameter of interest, the reliability metric describing a reliability of one or more measurement signals and/or respective one or more values of a parameter of interest with respect to an accurate prediction space associated with the trained inference model.

0007 The invention yet further provides a computer program product comprising machine-readable instructions for causing a processor to perform the method of the first aspect, and associated metrology apparatus and lithographic system.

0008 Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

0009 Embodiments of the invention will now be described, by way of example only, with reference to the accompanying schematic drawings in which corresponding reference symbols indicate corresponding parts, and in which:

Figure 1 depicts a lithographic apparatus;
Figure 2 depicts a lithographic cell or cluster in which an inspection apparatus according to the present invention may be used;
Figure 3 illustrates schematically an inspection apparatus adapted to perform angle-resolved scatterometry and dark-field imaging inspection methods;
Figure 4 is a flowchart describing a method for quantifying symmetric process variation (or asymmetric process variation) according to an embodiment;
Figure 5 is a flowchart describing a method for estimating a confidence metric for an overlay measurement according to an embodiment; and
Figure 6 is a flowchart describing a recipe update advisor method according to an embodiment.

DETAILED DESCRIPTION OF EXEMPLARY EMBODIMENTS

0010 Before describing embodiments of the invention in detail, it is instructive to present an example environment in which embodiments of the present invention may be implemented.

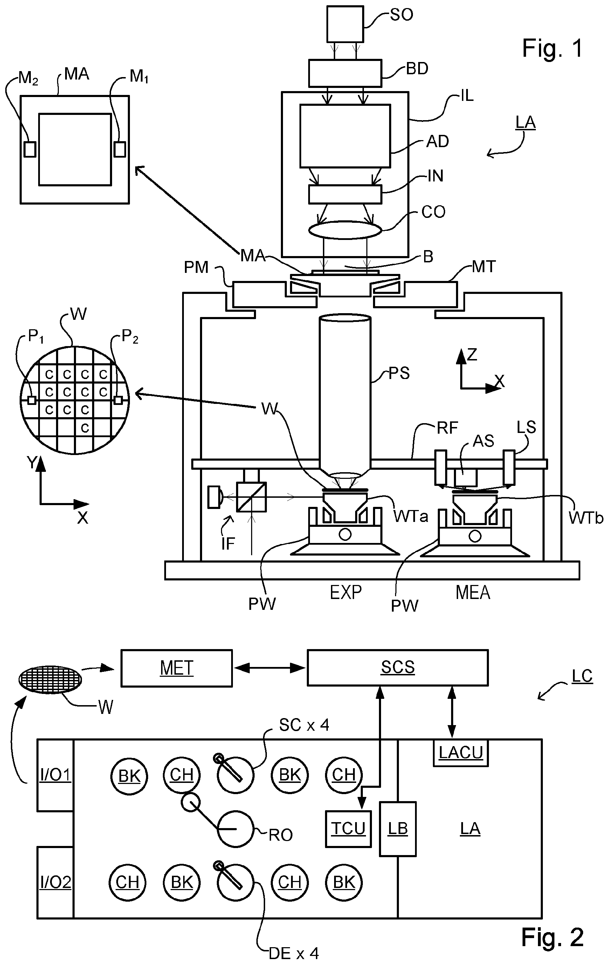

0011 Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

0012 The illumination system may include various types of optical components, such as refractive, reflective, magnetic, electromagnetic, electrostatic or other types of optical components, or any combination thereof, for directing, shaping, or controlling radiation.

0013 The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

0014 The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

0015 As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

0016 The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

0017 The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

0018 In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

0019 The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

0020 The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

0021 Patterning device (e.g., reticle/mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

0022 The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

0023 Combinations and/or variations on the above described modes of use or entirely different modes of use may also be employed.

0024 Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

0025 As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

0026 In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

0027 Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

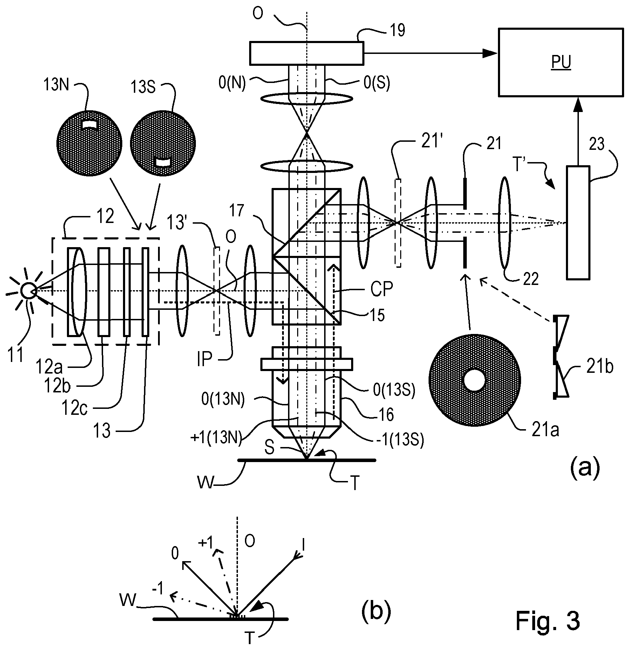

0028 A metrology apparatus suitable for use in embodiments of the invention is shown in Figure 3(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

0029 As shown in Figure 3(b), target structure T is placed with substrate W normal to the optical axis O of objective lens 16. The substrate W may be supported by a support (not shown). A ray of measurement radiation I impinging on target structure T from an angle off the axis O gives rise to a zeroth order ray (solid line 0) and two first order rays (dot-chain line +1 and double dot-chain line -1), hereafter referred to as a pair of complementary diffraction orders. It should be noted that the pair of complementary diffraction orders may be any higher order pair; e.g., the +2, -2 pair etc. and is not limited to the first order complementary pair. It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

0030 At least the 0 and +1 orders diffracted by the target structure T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

0031 A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

0032 In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

0033 Position errors may occur due to an overlay error (often referred to as "overlay"). The overlay is the error in placing a first feature during a first exposure relative to a second feature during a second exposure. The lithographic apparatus minimizes the overlay errors by aligning each substrate accurately to a reference prior to patterning. This is done by measuring positions of alignment marks on the substrate using an alignment sensor. More information on the alignment procedure can be found in U.S. Patent Application Publication No. US 2010-0214550, which is incorporated herein in its entirety by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus aims to minimize these focal positon errors by measuring the substrate surface topography prior to patterning using a level sensor. Substrate height corrections are applied during subsequent patterning to help assure correct imaging (focusing) of the patterning device onto the substrate. More information on the level sensor system can be found in U.S. Patent Application Publication No. US 2007-0085991, which is incorporated herein in its entirety by reference.

0034 Besides the lithographic apparatus LA and the metrology apparatus MT, one or more other processing apparatuses may be used during device production as well. An etching station (not shown) processes the substrates after exposure of the pattern into the resist. The etch station transfers the pattern from the resist into one or more layers underlying the resist layer. Typically etching is based on application of a plasma medium. One or more local etching characteristics may e.g. be controlled using temperature control of the substrate or directing the plasma medium using a voltage controlled ring. More information on etching control can be found in PCT Patent Application Publication No. WO 2011-081645 and U.S. Patent Application Publication No. US 2006-016561, which are incorporated herein in their entireties by reference.

0035 During the manufacturing of devices, it is desired that the process conditions for processing substrates using one or more processing apparatuses such as the lithographic apparatus or etching station remain stable such that properties of the features remain within certain control limits. Stability of the process is of particular significance for features of the functional parts of an electric device such as an IC, also referred to as product features. To help ensure stable processing, process control capabilities should be in place. Process control involves monitoring of processing data and implementation of means for process correction, e.g. control a processing apparatus based on one or more characteristics of the processing data. Process control may be based on periodic measurement by the metrology apparatus MT, often referred to as "Advanced Process Control" (further also referenced to as APC). More information on APC can be found in U.S. Patent Application Publication No. US 2012-008127, which is incorporated herein in its entirety by reference. A typical APC implementation involves periodic measurements on metrology features on the substrates to monitor and correct drifts associated with one or more processing apparatuses. The metrology features reflect the response to process variations of the product features. The sensitivity of the metrology features to process variations may be different compared to the sensitivity to the product features. In that case, a so-called "Metrology To Device" offset (also referenced to as MTD) may be determined.

0036 One reason for this is MTD offset is that the actual product structures are often much (orders of magnitude) smaller than the size of the target structures which are required for scatterometry or imaging measurements, and this difference in size can result in different parameter behavior (e.g., pattern placement and resulting overlay for metrology targets may differ from pattern placement and resulting overlay of actual structures). To mimic the behavior of product features, features within the metrology targets may be made smaller (e.g., of comparable size to the product structures, which can be referred to as at-resolution overlay ARO), incorporate segmented features, assist features or features with a particular geometry and/or dimension. A carefully designed metrology target ideally should respond in a similar fashion to process variations as do the product features. More information on metrology target design can be found in PCT Patent Application Publication No. WO 2015-101458 which is incorporated herein in its entirety by reference.

0037 In another approach, metrology may be performed directly on the product structure. This can be done using a scanning electron microscope (SEM) or an e-beam metrology apparatus for example. However, these devices are typically too slow for process control in a commercial (high-volume manufacturing HVM) environment. Another alternative, referred to as in-device metrology IDM, may comprise using a scatterometer based metrology apparatus to measure the product structure directly. Modern scatterometry tools such as illustrated in Figure 3 have the capability of measuring (at least) an asymmetry based metric (e.g., overlay) on such small structures. However, this is usually only possible for product structures (e.g., types of memory) which have sufficient regularization (are sufficiently periodic) such that they can act as an effective diffraction grating. All features within the spot add to the pupil, so features should be regular over the whole spot in order to get signal. Less regular product structures, such as (for example) logic structures, cannot be measured in this way.

0038 A known metrology technique is known as in-device metrology (IDM). In IDM, a wafer is measured (e.g., after-etch) using, for example, a metrology tool such as illustrated in Figure 3(a) (using the pupil imaging branch). The resulting optical signals, typically referred to herein as "pupils", each comprise an angularly resolved spectrum of measured values or signal parameter values (e.g., intensities, diffraction efficiencies or any other suitable parameter). These pupils are obtained from radiation scattered from a "target" on the substrate, and may comprise radiation from any one or more diffraction orders, where a diffraction order in this context includes the zeroth order (specularly reflected radiation). As such, a pupil may be obtained from only the zeroth order, only a single higher order or a combination of orders.

0039 In an embodiment, a pupil of the scattered radiation is measured, i.e., at a Fourier transform plane. The term pupil and pupil plane herein includes any conjugates thereof unless the context otherwise requires (for example, where a pupil plane of a particular optical system is being identified).

0040 The target may be a metrology target formed specifically for the purposes of metrology (e.g., a grating). Such a grating may, in some embodiments, mimic device structure such as logic structure (e.g., a regularized version of the product structure). Alternatively, the term "target" in the context of this disclosure may also include actual functional product structure, e.g., where it is sufficiently periodic or regular to perform metrology directly thereon.

0041 The incident measurement radiation used to measure a target may be polarized and a cross-polarizer used on the scattered radiation to divide the scattered radiation into two measurement channels, a cross-polarized channel (which provides cross-polarized pupils) and a co-polarized channel (which provides co-polarized pupils).

0042 An inference algorithm is used to infer a parameter of interest from the pupils, based on knowledge of the physics and process. In conventional IDM, the cross-polarized pupils are used to infer asymmetric parameters (e.g., overlay or tilts) and the co-polarized pupils used to infer symmetric parameters (e.g., critical dimension (CD) and height).

0043 Inferring overlay from only the cross-polarized pupil has its drawbacks. In particular, such an approach is not robust to process variation (e.g., variation in symmetrical parameters such as CD and height). The inference algorithm relies on a pre-determined "measurement recipe" which defines a per-pixel weighting for the pupil. This weighting is determined in a calibration for a particular process (particular stack dimensions etc.). In this way, overlay can be determined from a combination of intensities of the pixels that are appropriately weighted (wherein the weighting themselves acts a conversion factor of intensity (or other signal parameter) to overlay or which can be combined with a conversion factor from intensity to overlay). In such an example, an overlay signal can be described as:

$$OV = \sum_i w_i P_i^x$$

wherein the overlay signal *OV* is the weighted combination of the signal components of the cross-polarized pupil $P_i^x$

and $w_i$ are the respective weights for each of the signal components $P_i^x$ ($i$ is the pixel index). In an embodiment, the weights $w_i$ are a vector whose magnitude is related to the overlay. The main principles of such metrology techniques and the determination of a weighting are described in PCT application WO2019110254A1, which is incorporated herein by reference.

0044 The weighting may be calibrated in a data-driven approach, such that, for a given stack a weighting is learnt which can translate the cross-polarized pupil to an overlay value. However in such an approach, the process dependent component of the cross-polarized pupil is not taken into account. As such, if the process drifts and/or any process parameters are changed (either intentionally or otherwise), the overlay inference may become poor and inaccurate and a further calibration on the new stack may be required. This is because two stacks, each having the same overlay but different (e.g., symmetric) process effects, will generate different asymmetric pupils which result in a different overlay inference for each stack when the same weighting is applied.

0045 To address this issue, a process herein referred to as "dual pupil" has been developed. Increased robustness in dual pupil recipes is achieved through the capability of the dual pupil method to decode the status of the process, in order to recommend suitable inference weights which correctly extract overlay from the cross-polarized pupils.

0046 The main concept of the dual pupil method is the determination of a weighting from the co-polarized pupil obtained from wafer/target/stack and applying this weighting to the corresponding cross-polarized pupil, the weighting being optimized to compensate for the symmetric process effects such that, where each target has the same overlay but subject to different process effects, the inferred overlay will be (at least approximately) the same.

0047 The dual pupil method may comprise the construction of a model $M$ which determines weights for weighting the cross-polarized pupils (asymmetric measurement signal components) based on the co-polarized pupils (symmetric measurement signal components). As such, the model receives a co-polarized pupil and outputs an optimized weighting for inferring overlay from an associated cross-polarized pupil which follows local process variation. As such, the overlay $OV$ from a single cross-polarized pupil $P^x$ may be determined from :

$$OV = w \cdot P^x$$

where weighting $w$ is determined from

$$w = [1\ P^c]\,M$$

with $P^c$ being the co-polarized pupil. Therefore:

$$OV = [1\ P^c]\,M \cdot P^x$$

0048 In this way, the weighting determined by the model $M$ from the co-polarized pupils are optimized to account for different pupil response due to process variation.

0049 Dimensionality reduction techniques may be optionally employed to reduce the number of free parameters (e.g., by an order of magnitude of up to $10^3$) in a simplified dual pupil model. Such a method may comprise building a first matrix $U_c$ by finding the first $q_c$ principal components of the co-polarized pupils in the training data and a second matrix $U_x$ by finding the first $q_x$ principal components of the cross-polarized pupils in the training data. The reduced matrix model is trained to infer overlay in the asymmetric components based on the symmetric components.

0050 The dual pupil model may be built by collecting training data comprising corresponding sets of cross-polarized and co-polarized pupils from training wafers, and corresponding reference overlay data (e.g., from scanning electron microscope (SEM) wafers or self-reference calibration targets). The dual pupil model $M$ can then be found, for example, via a suitable machine learning approach.

0051 The determined dual pupil recipes can accurately measure overlay for wide process windows, extending the validity of the recipes over a long period. Understanding the underlying process in a newly monitored wafer is possible only if a similar process has been previously encountered during model training. If there has been considerable process variation/drift beyond process effects on which the model has been trained, then a trained dual pupil model may still lose accuracy. This is typical of data-driven models, which tend to extrapolate parameter estimates incorrectly when the measured data substantially differs from the training data used to train the model in a training phase.

0052 To counteract this process variation or drift outside of a training window, described herein are methods for determining and assessing a reliability metric describing the reliability of the measured metrology signal or a parameter of interest value (e.g., overlay value) derived therefrom with respect to an accurate prediction space (e.g., as determined by a training space defined by process variation covered by training data used to train an inference model, such as a dual-pupil model described above or otherwise, used in inferring a value for the parameter of interest). In an embodiment, the training data is used to train an inference model, which determines a weighting for a measured (e.g., cross-polarized) pupil so as to translate the metrology signal to the parameter of interest value.

0053 The inference model may comprise any suitable machine learning model including, for example, a neural network, a support vector machine, or a decision tree.

0054 A metrology signal in the context of this disclosure may comprise a raw pupil image or a processed pupil image. A processed pupil image may comprise a pupil image data in any form, including for example, one or more of: representation as a vector or matrix (e.g., of intensities, diffraction efficiencies or any other suitable parameter values) and/or having undergone any other processing techniques such as dimensionality reduction; i.e., the matrices $U_c$ and $U_c$ are metrology signals in the context of this disclosure.

0055 In an embodiment, the reliability metric may comprise a similarity metric which quantifies the similarity of a measured image or pupil (e.g., in a production or monitoring phase) to the measured images or pupils in the training data. The comparison may be a comparison of the co-polarized pupils, in an embodiment. Alternatively, or in addition, the comparison may be a comparison of the cross-polarized pupils. A comparison of co-polarized pupils may be used to assess whether symmetrical process variation (e.g., heights, CDs etc.) have been encountered in the training data, while a comparison of cross-polarized pupils may be used to assess whether non-overlay asymmetrical process variation (e.g., tilts and bottom grating asymmetries etc.) have been encountered in the training data.

0056 The proposed method provides a measure of similarity between the training and the monitoring process windows. The situation where significant process variation has occurred is not detectable by the dual pupil model alone. In principle, an external reference (e.g., an SEM measurement) could be used to verify that the dual pupil recipe is not extrapolating, i.e., measuring outside the range of the training process variation. SEM metrology is slow and can be impractical in a production setting. Therefore, the proposed method provides a metric for determining whether the measurement is reliable, which can then be used to base a decision as to whether further training should be performed. Only then would a reference measurement be performed (e.g., as a ground truth for the model update/additional training), as such or in an embodiment. The method may provide advice to take further wafer measurements to perform a recipe extend if needed (i.e., it advises the user to train a new data-driven model that comprises wafers processed within a current process window).

0057 The recipe health of dual pupil inference models is related to the similarity of process variation between training wafers (measured to obtain the training data used to train the model) and presently measured wafers. Variations which might affect the measurement accuracy may be categorized as:

- Stack/process variations which are geometrically symmetric, such as changing in the CD size or of the height of the stack;
- Additional/new asymmetries appearing in the stack which are unseen in the training phase, such as tilt, bottom grating asymmetry (BGA).

0058 To quantify such variations, it is assumed that the symmetric mode of co-polarized pupils carries information about symmetric stack variations; and the asymmetric mode of cross-polarized pupils carry information about asymmetric stack variations.


**Example Monitoring KPIs**

0059 Based on these concepts, in a more specific embodiment, two categories of monitoring key performance indicators (KPIs) are defined for use as a reliability metric. A first category, referred to herein as an SPV metric, assesses symmetric process variation (SPV), a second category, referred to herein as an APV metric, assesses asymmetric process variation (APV). Either one or both of these KPIs may be used in embodiments disclosed herein.

0060 Both of the SPV metric and APV metric may be used to compare whether the underlying process window (respectively, symmetric or asymmetric) is similar enough to the process window encountered during the training of a dual pupil inference model.

0061 In an embodiment, the monitoring KPIs may be based on the extraction of abstract features which correlate with process variation, in contrast to extracting the actual parameter of interest values, from the measurement pupils.

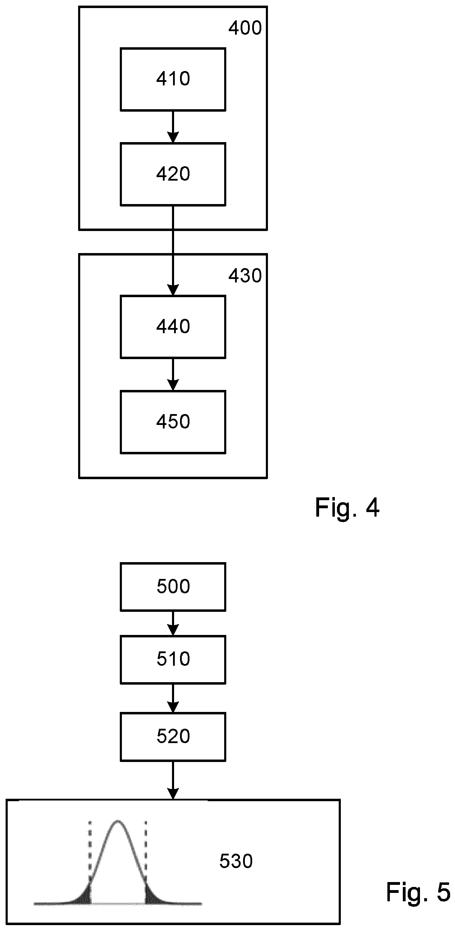

0062 Figure 4 is a flowchart describing a method for quantifying SPV using an SPV metric according to an embodiment, where the SPV metric is a KPI that compares co-polarized symmetric pupils from training wafers with those acquired in monitoring wafers. In a training phase 400, at step 410, co-polarized symmetric pupils (symmetric training data) of all targets used in training are organized in a symmetrical training data matrix $P_s$ where each column represents a pupil in vectorized form. At step 420, the singular value decomposition of matrix $P_s$ is computed and the first $k$ left singular vectors is stored in a matrix *U* (these are the abstract features described above).

0063 A monitoring phase 430 comprises a step 440 where, for each target measured (e.g., on a production or monitoring wafer), a co-polarized symmetric pupil is represented as a vector $\overrightarrow{P_s}$. Then, at step 450, an SPV metric value is determined.

0064 In a specific embodiment, the SPV metric value *SPV* may be determined as:

$$SPV = c \frac{\left\lVert (I - UU^T)\overrightarrow{P_s} \right\rVert^2}{\left\lVert \overrightarrow{P_s} \right\rVert^2},$$

where *I* is the identity matrix and c is a scaling factor that brings the 95th percentile of the training population to the customary value of 3. It should be appreciated that this is only an exemplary SPV metric and any SPV metric which, for example, compares similarity between symmetric image/pupil components (e.g., co-polarized pupils) between training data images and production/monitoring data images may be used.

0065 This SPV metric evaluates the ratio of "energy" (in a signal sense, more specifically the sum of the square of each pixel (e.g., intensity) value) of the co-polarized pupil which is lost after projecting the pupil outside the accurate prediction space or relevant pupil space observed during training. If this loss of energy is high, it means that the training pupil space (represented by *U*) is not capable to capture enough information content of the currently measured process, so that relevant information about the process might be lost. It may be appreciated that the matrix *U* can also used by the dual pupil model to extract information about process variation. Therefore, if such matrix is not suitable to capture all the relevant information content of a monitoring wafer, it is reasonable to expect that the dual pupil model cannot extract all the relevant information about the symmetric process variation, resulting in a poor extrapolation and loss of accuracy.

0066 The APV metric may be defined in a similar fashion, to the SPV metric to quantify differences in the asymmetric parameters, e.g., by extracting abstract features from the cross-polarized pupils (asymmetric measurement image components). As with the SPV metric, the APV metric may be defined in a number of different ways. In one specific example, the APV metric *APV* may be defined in terms of pupil residual energy after overlay extraction:

$$APV = \left\lVert \overrightarrow{P_a} - f^{-1}(ov) \right\rVert^2,$$

where $\overrightarrow{P_a}$ is the (vectorized) asymmetric cross-polarized pupil and $f^{-1}$ is the inverse of the overlay inference function; e.g., as created via the dual pupil method.

0067 In another embodiment, the APV metric may be defined as a projection method, in method similar to that described above in relation to the SPV metric:

$$APV = \left\lVert (I - VV^T)\overrightarrow{P_a} \right\rVert^2$$

where V contains the main left singular vector of the asymmetric (cross-polarized) training pupils, as before.

0068 A further embodiment for determining either or both of the SPV metric or APV metric may comprise a decomposition of the pupil residual energy in the relevant modes (i.e., symmetric image component or asymmetric image component respectively).

0069 A combination of any one or more SPV metrics described and/or any one or more APV metrics described may also be used to define one or more monitoring KPIs..

**Quantification of recipe accuracy using probabilistic modeling**

0070 Empirical observations have shown that an SPV metric such as disclosed herein is a very good predictor of the recipe accuracy in a probabilistic sense. This means that, if a target is determined to have a high value for the SPV metric, then the probability of the overlay inference being poor and inaccurate/erroneous is high. This concept may be captured and described, for example, using the model:

$$error \sim N(0, A \cdot SPV + B),$$

which states that the overlay measurement error follows a Gaussian distribution with zero-mean, and standard deviation that is an affine function of SPV. N is the normal (Gaussian) distribution. A and B are coefficients which transform the SPV metric into an overlay-related quantity. Coefficient A may be interpreted as a constant in [nm] units, and B as a quantity that captures all the error sources not related to process variation (e.g. photon noise, positioning error, etc.).

0071 Using such a probabilistic model, a confidence metric for each overlay measurement can be directly estimated. The SPV metric can inform how far a process is from the training process window, but it cannot really predict what the overlay error will be. To do this, a further model is proposed which relates the SPV metric to accuracy and an example of one such model is described below. Since the relation between the SPV metric and error is not one-to-one, but instead probabilistic (i.e., a high SPV metric value indicates a high probability of overlay error), the SPV metric can be used as a confidence metric describing a degree of confidence (in terms of statistical confidence intervals) on a certain measurement. Once the uncertainty is estimated, a threshold can be set based on the confidence interval (e.g., a threshold based on a user setting of overlay to be within a certain interval with 95% chance).

0072 In such an embodiment, an initial step may comprise estimating the parameters *A* and *B*. This can be done using a maximum likelihood optimization method.

0073 Figure 5 is a flowchart illustrating such a method. At step 500, a probability distribution of the error $p(e_i)$ on a target *i* may be defined by:

$$p(e_i) = \frac{1}{\sqrt{2\pi}(A \cdot SPV_i + B)^2} e^{\left(\frac{-0.5e_i^2}{(A \cdot SPV_i + B)^2}\right)}$$

0074 At step 510, the log-likelihood function $L(A,B)$ of the measurements becomes:

$$L(A, B) = -\sum_i \log(A \cdot SPV_i + B)^2 - \sum_i \frac{e_i^2}{(A \cdot SPV_i + B)^2}$$

0075 At step 520, the parameters *A* and *B* are found by maximizing the log-likelihood function $L(A,B)$. At step 530, a thresholding SPV is found which provides a confidence interval (which, for example, can be found by inverting the cumulative distribution of the fitted Gaussian density).

**Recipe update advisor**

0076 This section describes a method to advise recipe updates. For every monitored wafer, the method informs the user if a (e.g., dual pupil) recipe should be updated by including that wafer as a training wafer. In this way, the process window seen during training is extended, if necessary.

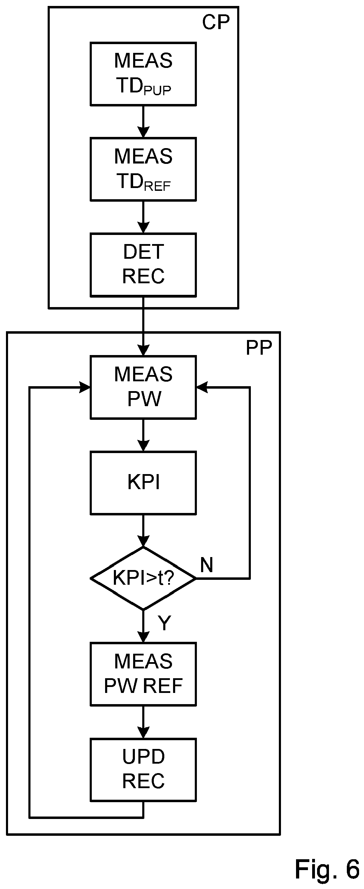

0077 Figure 6 is a flowchart describing such a method. In a training or calibration phase TP, training pupil images TD$_{PUP}$ are obtained (e.g., using an optical metrology tool such as illustrated in Figure 3(a), along with corresponding ground truth reference data TD$_{REF}$ (e.g., measured using an SEM or optically using self-reference biased target clusters). Using this training data, a dual pupil recipe is determined DET RES and the appropriate monitoring KPI calibrated (e.g., according to training phase 400 of Figure 4, to calibrate the SPV metric). In a production phase PP, the next monitoring or production wafer PW is measured MEAS PW, and one or more monitoring KPIs calculated KPI. For example, for every measurement location SPV and/or APV metrics may be calculated. Based on this, a wafer-level statistical metric value of the SPV and/or APV metric may be determined. If the determined value is above a predefined threshold KPI>t?, then the user may be advised to take an appropriate action. Such an appropriate action may include extend the recipe to include this wafer, and/or one or more subsequent wafers depending on e.g., time constraints. Assuming that this advice is acted upon, the production wafer may be measured MEAS PW REF to determine reference data for it (e.g., via SEM or reference target cluster metrology) and the recipe updated UPD REC, e.g., using a similar method as the recipe training. The method then proceeds with the next production wafer (whether an update was deemed necessary or not).

0078 In the above method, wafer-level statistical metric which quantifies wafer-level accuracy is defined and compared to a threshold. Two proposed methods for determining the wafer-level statistical metric and threshold will be described, by way of examples.

0079 A first approach comprises a probabilistic threshold setting method based upon the probabilistic modeling methodology described above. This method uses the probabilistic model to compute wafer-level statistics and thresholding. The method relies on two user settings: a maximum allowed error $X$ (e.g., in nm) on overlay measurement; and the probability $Y$ of violating this on the wafer. Based on a required performance specification:

$$P(|e| < X) = Y$$

where $e$ is an error measure, a wafer-level statistic and related threshold can be determined. In the context of the SPV metric, the following error function erf may be solved:

$$\mathrm{erf}\left(\frac{X}{\sqrt{2}(A \cdot \overline{SPV} + B)^2}\right) = Y$$

the solution to find threshold $\overline{SPV}$ may be found via:

$$\overline{SPV} = \frac{X - \sqrt{2}\mathrm{erf}^{-1}(Y)B}{\sqrt{2}\mathrm{erf}^{-1}(Y)A}$$

By way of a specific example, if it is desired that a 5nm specification is violated at most for 10% of targets, then:

$$\overline{SPV} = \frac{5 - \sqrt{2}\mathrm{erf}^{-1}(0.9)B}{\sqrt{2}\mathrm{erf}^{-1}(0.9)A}$$

0080 A second approach comprises an empirical threshold setting. This method is based on defining a wafer-level statistical metric for SPV and/or APV that suitably correlates with wafer-level overlay accuracy. Separately, a threshold for this wafer level statistics may be defined in order to recommend more accurate recipe updates.
0081 For the wafer-level statistics (WLS), the following KPIs may be used:

- 20th percentile of the SPV/APV wafer population;
- Median of the SPV/APV wafer population.

0082 To advise on a recipe update, the above WLS may be compared with the same statistics computed on wafers whose accuracy has been verified; e.g., using external reference (SEM) or self-reference target metrology. Assuming, for example, that N wafers have been verified as being within specification with respect to accuracy, then the threshold $t$:

$$t = median_{N\,wafers}(WLS) + 2.25\,IQR_{N\,wafers}(WLS),$$

where $IQR$ denotes inter-quartile range.
0083 In an embodiment, should a reliability metric or monitoring KPI indicate that an image or value is unreliable, a further check may be performed prior to any retraining to check whether the image has been correctly measured, so as to prevent device defects or environmental effects being included in the model.
0084 Further embodiments of the present non-transitory computer-readable medium, method and metrology tool are disclosed in the subsequent list of numbered clauses:

1. A method of determining a reliability metric describing a reliability of metrology signal and/or a parameter of interest value derived therefrom, the method comprising;
obtaining a trained inference model for inferring a value for a parameter of interest from a measurement signal;
obtaining one or more measurement signals and/or respective one or more values of a parameter of interest derived therefrom using said trained inference model; and
determining at least one reliability metric value for the one or more measurement signals and/or respective one or more values of a parameter of interest, the reliability metric describing a reliability of one or more measurement signals and/or respective one or more values of a parameter of interest with respect to an accurate prediction space associated with the trained inference model.

2. A method as defined in clause 1, wherein said accurate prediction space is related to a training of said trained inference model.

3. A method as defined in clause 1 or 2, wherein said trained inference model is operable to determine a weighting for each of said one or more measurement signals or respective components thereof.

4. A method as defined in clause 3, wherein said parameter of interest is an asymmetric parameter and said trained inference model is operable to determine a weighting for an asymmetric measurement signal component of each of said one or more measurement signals.

5. A method as defined in clause 4, wherein said parameter of interest is overlay or focus.

6. A method as defined in clause 3, wherein said parameter of interest is a symmetric parameter and said trained inference model is operable to determine a weighting for a symmetric measurement signal component of each of said one or more measurement signals.

7. A method as defined in clause 6, wherein said parameter of interest is critical dimension or height.

8. A method as defined in any of clauses 3 to 7, wherein said weighting translates each of said one or more measurement signals or respective components thereof to a respective parameter of interest value.

9. A method as defined in any preceding clause, wherein said accurate prediction space is defined by a training process window described by training data used in said training, said training process window describing the bounds of process variation comprised within said training data.

10. A method as defined in clause 9, wherein said training data comprises training measurement signals and corresponding reference data comprising ground truth values for the parameter of interest for each of said training measurement signals.

11. A method as defined in any preceding clause, wherein said reliability metric comprises at least one similarity metric which quantifies the similarity of said one or more measurement signals or respective components thereof to at least one of said training measurement signals or corresponding respective components thereof.

12. A method as defined in clause 11, wherein said at least one similarity metric comprises a symmetric process variation metric which quantifies the similarity of a symmetric measurement signal component of each of said one or more measurement signals to a symmetric measurement signal component of at least one of said training measurement signals.

13. A method as defined in clause 12, wherein said symmetric process variation metric evaluates the loss of an energy metric of said symmetric measurement signal component of each of said one or more measurement signals which after projecting the pupil outside the accurate prediction space.

14. A method as defined in any preceding clause, wherein said at least one similarity metric comprises an asymmetric process variation metric which quantifies the similarity of an asymmetric measurement signal component of each of said one or more measurement signals to an asymmetric measurement signal component of at least one of said training measurement signals.

15. A method as defined in clause 14, wherein said asymmetric process variation metric evaluates pupil residual energy after extraction of the parameter of interest.

16. A method as defined in clause 14, wherein said asymmetric process variation metric evaluates the loss of an energy metric of said asymmetric measurement signal component of each of said one or more measurement signals which after projecting the pupil outside the accurate prediction space.

17. A method as defined in clause 13 or 16, wherein said energy metric comprises a ratio of the sum of the square of each value of said symmetric measurement signal component of each of said one or more measurement signals.

18. A method as defined in any preceding clause, wherein said trained inference model comprises a neural network, a support vector machine, or a decision tree.

19. A method as defined in clause 1 or 2, wherein said trained inference model comprises a neural network and said determining at least one reliability metric value comprises:

    randomly altering the state of one or more neural connections in the trained inference model;
    obtaining a value for the parameter of interest using said randomly altered trained inference model;
    repeating the preceding two steps a plurality of times; and
    determining the reliability metric from a resultant distribution of said values for the parameter of interest.

20. A method as defined in any preceding clause, comprising:

    assessing said at least one reliability metric; and,
    should said reliability metric indicate that at least one of said measurement signals and/or respective values of a parameter of interest is not reliable, prompting an update of said trained model to include the at least one unreliable measurement signals and/or respective values of a parameter of interest, and/or measurement signals and/or respective values of a parameter of interest from one or more subsequently measured substrates.

21. A method as defined clause 20, wherein, should an update be prompted, the method comprises:

further measuring one or more structures corresponding to said at least one unreliable measurement signals and/or respective values of a parameter of interest, and/or one or more structures on said one or more subsequently measured substrates to obtain respective ground truth values; and
further training said trained model with the at least one unreliable measurement signals and/or respective values of a parameter of interest and the respective ground truth values.

22. A method as defined in clause 20 or 21, wherein said assessing said at least one reliability metric comprises assessing said at least one reliability metric against a respective threshold value for said reliability metric.
23. A method as defined in clause 22, comprising a threshold setting step for setting said threshold.
24. A method as defined in clause 23, wherein said threshold setting step comprises:

constructing a probabilistic model based on said reliability metric;
obtaining a maximum allowed error on each parameter of interest value; and a probability of violating this on the substrate; and
using said probabilistic model, said maximum allowed error and said probability to compute substrate-level statistical data from a plurality of said measurement signals obtained from one or more substrates, and said threshold.

25. A method as defined in clause 23, wherein said threshold setting step comprises:

defining a substrate-level statistical metric for said reliability metric that correlates with a substrate-level accuracy for the parameter of interest, and
defining a threshold for that substrate based on comparing the substrate-level statistical metric with an equivalent metric from verified reference data.

26. A method as defined in clause 15, wherein said wafer-level statistical metric comprises a particular percentile of the reliability metric substrate population.
27. A method as defined in clause 26, wherein said particular percentile comprises the 20th percentile or median of the substrate population.
28. A method as defined in any preceding clause, wherein each measurement signal and/or component thereof comprises a processed or unprocessed angularly resolved array of values.
29. A method as defined in any preceding clause, wherein each measurement signal and/or component thereof has undergone a dimensionality reduction process.
30. A method as defined in any preceding clause, performing metrology on one or more structures on one or more substrates to obtain said one or more metrology signals.
31. A computer program comprising processor readable instructions which, when run on suitable processor controlled apparatus, cause the processor controlled apparatus to perform the method of any of clauses 1 to 30.
32. A computer program carrier comprising the computer program of clause 31.
33. A processing apparatus comprising:

a processor; and
a computer program carrier comprising the computer program of clause 32.

34. A metrology apparatus comprising the processing apparatus of clause 33.

0085 The type of inference model described above is only one example of an inference model that may be used for inferring a parameter of interest. For a different type of inference model based on neural networks, a proposed method for assessing the reliability of a parameter of interest value (e.g., overlay value) derived from a measurement image with respect to an accurate prediction space may use Monte-Carlo dropout techniques. In such an embodiment, when measuring overlay, one or more neural connections in the model may be randomly turned off. This may be repeated with different neural connections turned off, such that for each repetition the inference model outputs a different parameter estimate. By observing the resultant distribution of outputted an assessment of uncertainty in the parameter inference may be made (a reliability metric value). As with other embodiments disclosed herein, this reliability metric may be used to base a decision on whether the model training should be extended (e.g., high uncertainty suggests that the overlay inference is untrustworthy and the model should be extended).

0086 The above method has been described in terms of overlay, but other parameter of interest may be determined using an inference model based on concepts herein. For example, focus may be inferred from focus targets or structures with a formed asymmetry dependent on the actual scanner focus used to expose the target. The methods described herein are equally applicable to focus metrology using such targets and any mention of overlay above may be substituted with focus. Other parameters of interest measurable via the co-polarized pupil (symmetric component), such as CD or height, may also benefit from the concepts disclosed herein and the methods are therefore applicable to these.

0087 The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

0088 The term "lens", where the context allows, may refer to any one or combination of various types of optical components, including refractive, reflective, magnetic, electromagnetic and electrostatic optical components.

0089 The term target should not be construed to mean only dedicated targets formed for the specific purpose of metrology. The term target should be understood to encompass other structures, including product structures, which have properties suitable for metrology applications.

0090 The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

0091 The breadth and scope of the present invention should not be limited by any of the above-described exemplary embodiments, but should be defined only in accordance with the following claims and their equivalents.

## Claims

1. A method of determining a reliability metric describing a reliability of metrology signal and/or a parameter of interest value derived therefrom, the method comprising;
   obtaining a trained inference model for inferring a value for a parameter of interest from a measurement signal;
   obtaining one or more measurement signals and/or respective one or more values of a parameter of interest derived therefrom using said trained inference model; and
   determining at least one reliability metric value for the one or more measurement signals and/or respective one or more values of a parameter of interest, the reliability metric describing a reliability of one or more measurement signals and/or respective one or more values of a parameter of interest with respect to an accurate prediction space associated with the trained inference model.

2. A method as claimed in claim 1, wherein said accurate prediction space is related to a training of said trained inference model.

3. A method as claimed in claim 1 or 2, wherein said trained inference model is operable to determine a weighting for each of said one or more measurement signals or respective components thereof.

4. A method as claimed in claim 3, wherein said parameter of interest is an asymmetric parameter and said trained inference model is operable to determine a weighting for an asymmetric measurement signal component of each of said one or more measurement signals.

5. A method as claimed in any of claims 3 or 4, wherein said weighting translates each of said one or more measurement signals or respective components thereof to a respective parameter of interest value.

6. A method as claimed in any preceding claim, wherein said accurate prediction space is defined by a training process window described by training data used in said training, said training process window describing the bounds of process variation comprised within said training data.

**7.** A method as claimed in any preceding claim, wherein said reliability metric comprises at least one similarity metric which quantifies the similarity of said one or more measurement signals or respective components thereof to at least one of said training measurement signals or corresponding respective components thereof.

**8.** A method as claimed in claim 7, wherein said at least one similarity metric comprises an asymmetric process variation metric which quantifies the similarity of an asymmetric measurement signal component of each of said one or more measurement signals to an asymmetric measurement signal component of at least one of said training measurement signals.

**9.** A method as claimed in claim 8, wherein said asymmetric process variation metric evaluates pupil residual energy after extraction of the parameter of interest.

**10.** A method as claimed in any preceding claim, comprising:

assessing said at least one reliability metric; and,
should said reliability metric indicate that at least one of said measurement signals and/or respective values of a parameter of interest is not reliable, prompting an update of said trained model to include the at least one unreliable measurement signals and/or respective values of a parameter of interest, and/or measurement signals and/or respective values of a parameter of interest from one or more subsequently measured substrates.

**11.** A method as claimed claim 10, wherein, should an update be prompted, the method comprises:

further measuring one or more structures corresponding to said at least one unreliable measurement signals and/or respective values of a parameter of interest, and/or one or more structures on said one or more subsequently measured substrates to obtain respective ground truth values; and
further training said trained model with the at least one unreliable measurement signals and/or respective values of a parameter of interest and the respective ground truth values.

**12.** A method as claimed in claim 10 or 11, wherein said assessing said at least one reliability metric comprises assessing said at least one reliability metric against a respective threshold value for said reliability metric.

**13.** A method of assessing a reliability metric, the method comprising;
assessing said at least one reliability metric; and,
should said reliability metric indicate that at least one of said measurement signals and/or respective values of a parameter of interest is not reliable, prompting an update of a trained inference model to include the at least one unreliable measurement signals and/or respective values of a parameter of interest, and/or measurement signals and/or respective values of a parameter of interest from one or more subsequently measured substrates.

**14.** A computer program comprising processor readable instructions which, when run on suitable processor controlled apparatus, cause the processor controlled apparatus to perform the method of any of claims 1 to 13.

**15.** A metrology apparatus comprising:

a processor; and
a computer program carrier comprising the computer program of claim 14.

Fig. 1

Fig. 2

Fig. 3

Fig. 4

Fig. 5

Fig. 6

Europäisches
Patentamt

European
Patent Office

Office européen
des brevets

# EUROPEAN SEARCH REPORT

Application Number

EP 21 18 3254

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/142466 A1 (OPHIR BOAZ [IL] ET AL) 13 May 2021 (2021-05-13) * paragraphs [0002], [0014] - [0031]; figures 1,2 * | 1-15 | INV. G03F7/20 |
| A | WO 2020/182468 A1 (ASML NETHERLANDS BV [NL]) 17 September 2020 (2020-09-17) * paragraph [0098] * | 1-15 | |
| A | KR 2017 0030552 A (KLA-TENCOR CORP [US]) 17 March 2017 (2017-03-17) * paragraphs [0023], [0039], [0042], [0048] * | 1-15 | |
| A | EP 3 654 103 A1 (ASML NETHERLANDS BV [NL]) 20 May 2020 (2020-05-20) * paragraphs [0049], [0050] * | 1-15 | |

| | |
|---|---|
| TECHNICAL FIELDS SEARCHED (IPC) | |
| G03F | |

The present search report has been drawn up for all claims

| Place of search | Date of completion of the search | Examiner |
|---|---|---|
| Munich | 10 December 2021 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 ...........................................................................
& : member of the same patent family, corresponding document

EPO FORM 1503 03.82 (P04C01)

## EP 4 113 210 A1

### ANNEX TO THE EUROPEAN SEARCH REPORT
### ON EUROPEAN PATENT APPLICATION NO.

EP 21 18 3254

This annex lists the patent family members relating to the patent documents cited in the above-mentioned European search report.
The members are as contained in the European Patent Office EDP file on
The European Patent Office is in no way liable for these particulars which are merely given for the purpose of information.

10-12-2021

| Patent document cited in search report | | Publication date | Patent family member(s) | | Publication date |
|---|---|---|---|---|---|
| US 2021142466 | A1 | 13-05-2021 | TW 202124943 A<br>US 2021142466 A1<br>WO 2020142301 A1 | | 01-07-2021<br>13-05-2021<br>09-07-2020 |
| WO 2020182468 | A1 | 17-09-2020 | CN 113574458 A<br>TW 202040265 A<br>WO 2020182468 A1 | | 29-10-2021<br>01-11-2020<br>17-09-2020 |
| KR 20170030552 | A | 17-03-2017 | CN 106663646 A<br>IL 249256 A<br>KR 20170030552 A<br>TW 201606294 A<br>US 2016003609 A1<br>WO 2016007413 A1 | | 10-05-2017<br>31-05-2020<br>17-03-2017<br>16-02-2016<br>07-01-2016<br>14-01-2016 |
| EP 3654103 | A1 | 20-05-2020 | CN 113168108 A<br>EP 3654103 A1<br>KR 20210075156 A<br>TW 202036168 A<br>TW 202119138 A<br>WO 2020099011 A1 | | 23-07-2021<br>20-05-2020<br>22-06-2021<br>01-10-2020<br>16-05-2021<br>22-05-2020 |

EPO FORM P0459

For more details about this annex : see Official Journal of the European Patent Office, No. 12/82

**REFERENCES CITED IN THE DESCRIPTION**

**Patent documents cited in the description**

- US 2006033921 A1
- US 2010201963 A1
- US 20100328655 A1
- US 2011069292 A1
- US 20110027704 A
- US 20110043791 A
- US 2011102753 A1
- US 20120044470 A
- US 20120123581 A
- US 20130258310 A
- US 20130271740 A
- WO 2013178422 A1
- WO 2017186483 A1
- US 20100214550 A
- US 20070085991 A
- WO 2011081645 A
- US 2006016561
- US 2012008127
- WO 2015101458 A
- WO 2019110254 A1